# EUROPEAN PATENT APPLICATION

(11) **EP 4 395 149 A1**
(43) Date of publication of application: **03.07.2024**
(21) Application number: 23801664.6
(22) Date of filing: 16.08.2023
(51) Int. Cl.: H02M 3/07

(54) **POWER INPUT CIRCUIT, ELECTRONIC DEVICE INCLUDING POWER INPUT CIRCUIT, AND METHOD FOR OPERATING SAME**

(30) Priority: 16.11.2022 KR 20220153970; 05.12.2022 KR 20220167724
(71) Applicant: Samsung Electronics Co., Ltd., Suwon-si, Gyeonggi-do (KR)
(72) Inventor: CHOI, Hangseok, Suwon-si, Gyeonggi-do 16677 (KR); KANG, Sangwoo, Suwon-si, Gyeonggi-do 16677 (KR)
(74) Representative: Gulde & Partner
(86) International application number: PCT/KR2023/012081
(87) International publication number: WO 2024/106700

(57) **Abstract**

According to an embodiment, a power input circuit may include a charge pump and an LC filter. The charge pump may include a first switch configured to receive input power from a power source. The charge pump may include a second switch electrically connected to the first switch. The charge pump may include a third switch configured to receive the input power from the power source. The charge pump may include a fourth switch electrically connected to the third switch. The charge pump may include a first capacitor. The LC filter may include a first inductor and a second capacitor. The first inductor of the LC filter may be electrically connected to the first capacitor.

## Description

### [Technical Field]

Embodiments of the disclosure relate to a power input circuit, an electronic device including a power input circuit, and a method of operation thereof.

### [Background Art]

As a radio frequency (RF) power amplifier, a linear-type amplifier is used in order to ensure a high operating frequency, and RF output may dynamically change over time. The power supplied to a power amplifier is required to be sufficiently high to ensure a maximum output, and when the output of the power amplifier is lower than the supplied power, the efficiency thereof is relatively low. In order to solve this problem, an average power tracking method in which the power supply of an RF power amplifier dynamically changes according to the output power thereof is being recently applied.

A power supply circuit (e.g., a power input circuit) used in average power tracking needs to be able to generate an output voltage of 1-5 V by being supplied with an input voltage from a battery having a voltage between 3.3 V and 4.4 V. Therefore, a general buck converter allowing only an output voltage lower than an input voltage is not usable for the power supply circuit, and a converter capable of supplying an output voltage lower or higher than an input voltage should be used.

### [Detailed Description of the Invention]

### [Technical Solution]

According to an embodiment, a power input circuit includes a charge pump and an LC filter. The charge pump includes a first switch configured to receive input power from a power source, the input power being input through a first end of the first switch. The charge pump includes a second switch electrically connected to the first switch, a second end of the first switch being electrically connected to a first end of the second switch, and a second end of the second switch being electrically connected to the ground. The charge pump includes a third switch configured to receive the input power from the power source, the input power being input through a first end of the third switch. The charge pump includes a fourth switch electrically connected to the third switch, a first end of the fourth switch being electrically connected to a second end of the third switch, and a second end of the fourth switch being electrically connected to the ground. The charge pump includes a first capacitor, a first end of the first capacitor being electrically connected to the second end of the first switch, and a second end of the first capacitor being electrically connected to the second end of the third switch. The LC filter includes a first inductor and a second capacitor. The first inductor of the LC filter is electrically connected to the second end of the first capacitor.

According to an embodiment, an electronic device may include a charge pump, an LC filter, and a processor. The charge pump may include a first switch configured to receive input power from a power source, the input power being input through a first end of the first switch. The charge pump may include a second switch electrically connected to the first switch, a first end of the second switch being electrically connected to a second end of the first switch, and the second end of the second switch being electrically connected to the ground. The charge pump may include a third switch configured to receive the input power from the power source, the input power being input through a first end of the third switch. The charge pump may include a fourth switch electrically connected to the third switch, a first end of the fourth switch being electrically connected to a second end of the third switch, and the second end of the fourth switch being electrically connected to the ground. The charge pump may include a first capacitor, a first end of the first capacitor (225) being electrically connected to the second end of the first switch, and a second end of the first capacitor (225) being electrically connected to the second end of the third switch. The LC filter may include a first inductor and a second capacitor. The first inductor of the LC filter may be electrically connected to the second end of the first capacitor.

According to an embodiment, an electronic device includes a power input circuit, a power source, and a processor.

### [Brief Description of Drawings]

FIG. 1 is a block diagram of an electronic device according to an embodiment;
FIG. 2 is a circuit diagram of a power input circuit according to an embodiment;
FIG. 3 is a diagram illustrating an operation of a power input circuit and an electronic device according to an embodiment;
FIG. 4 is a diagram illustrating an operation of a power input circuit and an electronic device according to an embodiment;
FIG. 5 is a diagram illustrating an operation of a power input circuit and an electronic device according to an embodiment;
FIG. 6 is a diagram illustrating an operation of a power input circuit and an electronic device according to an embodiment; and
FIG. 7 is a diagram illustrating an operation of a power input circuit and an electronic device according to an embodiment.

### [Mode for Carrying out the Invention]

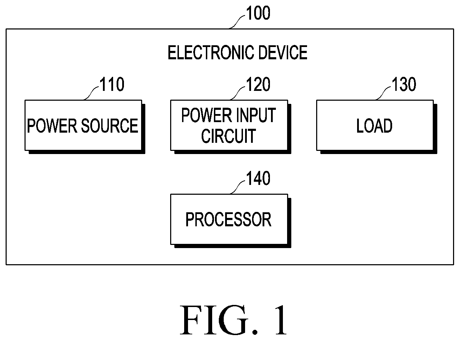

FIG. 1 is a block diagram of an electronic device according to an embodiment.

According to an embodiment, referring to FIG. 1, an electronic device 100 may include a power source 110, a power input circuit 120, a load 130, and/or a processor 140. An operation of the electronic device 100 may be understood as an operation of the processor 140. The processor 140 may control other elements included in the electronic device 100. The processor 140 may control the power input circuit 120 (or an element included in the power input circuit 120). For example, the processor 140 may control the power input circuit 120, thereby providing the power provided from the power source 110, to the load 130 via the power input circuit 120. For example, the processor 140 may convert, via the power input circuit 120, the power provided from the power source 110, and provide the converted power to the load 130.

According to an embodiment, the power source 110 may provide input power to the power input circuit 120. The power input circuit 120 may be provided with input power from the power source 110. There is no limit to the type of the power source 110 and the implementation method thereof. The "input power" may be power input to the power input circuit 120.

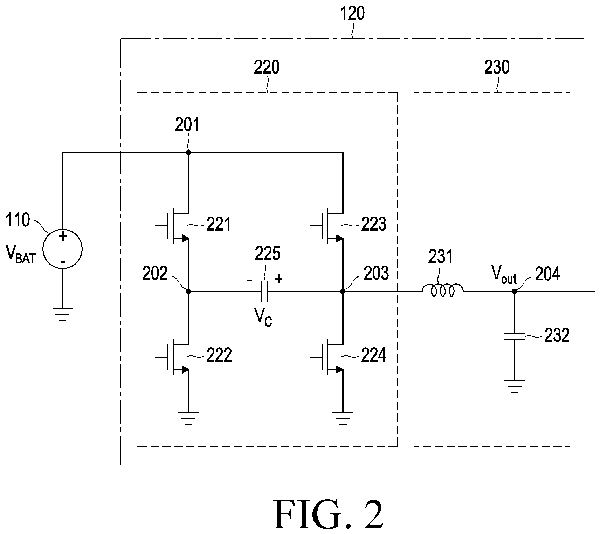

According to an embodiment, the power input circuit 120 may convert the input power provided from the power source 110. The power input circuit 120 may convert the voltage (e.g., input voltage) of the input power provided from the power source 110, and output an output power having the converted voltage (e.g., output voltage). The "output power" may be power output from the power input circuit 120. The power input circuit 120 may provide output power to the load 130. There is no limit to the type of the load 130 and the implementation method thereof. A circuit diagram of the power input circuit 120 will be described with reference to FIG. 2.

FIG. 2 is a circuit diagram of a power input circuit according to an embodiment.

FIG. 2 is a circuit diagram of the power source 110 and the power input circuit 120 included in the electronic device 100 according to an embodiment.

According to an embodiment, referring to FIG. 2, the power input circuit 120 includes a charge pump 220 and an LC filter 230. The power input circuit 120 may convert the power (e.g., input power) provided from the power source 110 and output the converted power (e.g., output power) via the charge pump 220 and the LC filter 230. The power input circuit 120 may convert the voltage of input power and output an output power having the converted voltage via the charge pump 220 and the LC filter 230.

According to an embodiment, the charge pump 220 includes a first switch 221, a second switch 222, a third switch 223, a fourth switch 224, and a first capacitor 225. The first switch 221, the second switch 222, the third switch 223, and the fourth switch 224 may be implemented as transistors. There is no limit to the implementation method of the first switch 221, the second switch 222, the third switch 223, and the fourth switch 224. The first switch 221 receives input power from the power source 110. A first end of the first switch 221 may be connected to an input node 201. The charge pump 220 may receive input power from the power source 110 through the first end of the first switch 221. The second switch 222 is electrically connected to the first switch 221. A second end of the first switch 221 and a first end of the second switch 222 are electrically connected to each other. A second end of the second switch 222 is electrically connected to the ground. The third switch 223 receives input power from the power source 110. A first end of the third switch 223 may be connected to the input node 201. The charge pump 220 may receive input power from the power source 110 through the first end of the third switch 223. The fourth switch 224 is electrically connected to the third switch 223. A second end of the third switch 223 and a first end of the fourth switch 224 are electrically connected to each other. A second end of the fourth switch 224 is electrically connected to the ground. The first capacitor 225 may be electrically connected between the first switch 221 and the second switch 222. A first end 202 of the first capacitor 225 is electrically connected to the second end of the first switch 221 and may be electrically connected to the first end of the second switch 222. The first capacitor 225 may be electrically connected between the third switch 223 and the fourth switch 224. A second end of the first capacitor 225 is electrically connected to the second end of the third switch 223 and may be electrically connected to the first end of the fourth switch 224. The second end of the first capacitor 225 may be connected to an input node 203 of the LC filter 230. The first capacitor 225 may be charged or discharged due to the voltage difference between the second end (e.g., the input node 203 of the LC filter 230) of the first capacitor 225 and the first end of the first capacitor 225.

The charge pump 220 may output switching power to the input node 203 of the LC filter 230. The "switching power" may be power having a voltage converted by the charge pump 220, based on input power. The charge pump 220 may output switching power to the input node 203 of the LC filter 230, based on the input power provided from the power source 110. The charge pump 220 may output switching power to the LC filter 230 through the input node 203 of the LC filter 230.

According to an embodiment, the LC filter 230 includes an inductor 231 and a second capacitor 232. The inductor 231 of the LC filter 230 is electrically connected to the second end of the first capacitor 225 of the charge pump 220. A first end of the inductor 231 of the LC filter 230 may be electrically connected to the second end of the first capacitor 225 of the charge pump 220. A second end of the inductor 231 of the LC filter 230 may be electrically connected to a first end of the second capacitor 232 of the LC filter 230. A second end of the second capacitor 232 of the LC filter 230 may be electrically connected to the ground. The LC filter 230 may receive switching power via the inductor 231. The LC filter 230 may receive switching power from the charge pump 220 via the inductor 231. The LC filter 230 may output an output power through an output node 204 of the LC filter 230 between the inductor 231 and the second capacitor 232, based on the switching power. The voltage (e.g., output voltage) of the output power output via the output node 204 of the LC filter 230 between the inductor 231 and the second capacitor 232 of the LC filter 230 may be determined based on the voltage of the switching power provided through the input node 203 of the LC filter 230.

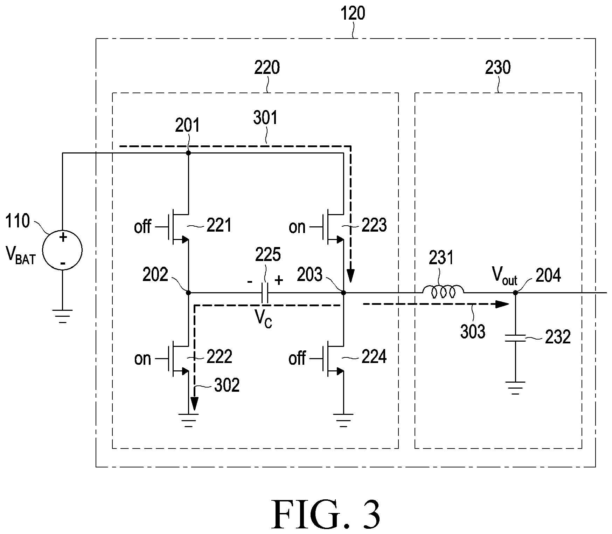

FIG. 3 is a diagram illustrating an operation of a power input circuit and an electronic device according to an embodiment.

A first mode may be described with reference to FIG. 3. The "first mode" may be a mode in which the voltage of the input power input to the charge pump 220 and the voltage of the switching power output to the input node 203 of the LC filter 230 are substantially the same. The charge pump 220 may output, based on the first mode and to the input node 203 of the LC filter 230, switching power having a voltage with a magnitude substantially the same as that of the voltage of the input power input to the charge pump 220. The first mode may be a combination of the first switch 221 being turned off, the second switch 222 being turned on, the third switch 223 being turned on, and the fourth switch 224 being turned off. The processor 140 may control the charge pump 220 so that the charge pump 220 operates in the first mode. The processor 140 may control the charge pump 220 in the first mode to output, via the charge pump 220, switching power having a voltage with a magnitude substantially the same as that of the input voltage of input power. The processor 140 may control the first switch 221 to be turned off, the second switch 222 to be turned on, the third switch 223 to be turned on, and the fourth switch 224 to be turned off, so as to allow the charge pump 220 to operate in the first mode. Referring to FIG. 3, in the first mode, the input power provided from the power source 110 may be transferred to the input node 203 of the LC filter 230 through a first path 301 including the third switch 223. The first capacitor 225 may be charged, based on the first mode and through a second path 302, to have a voltage with a magnitude substantially the same as that of the voltage (e.g., input voltage) of the input power provided from the power source 110. In the first mode, the LC filter 230 may receive, through a third path 303, switching power having a voltage with a magnitude substantially the same as that of the voltage (e.g., input voltage) of the input power provided from the power source 110.

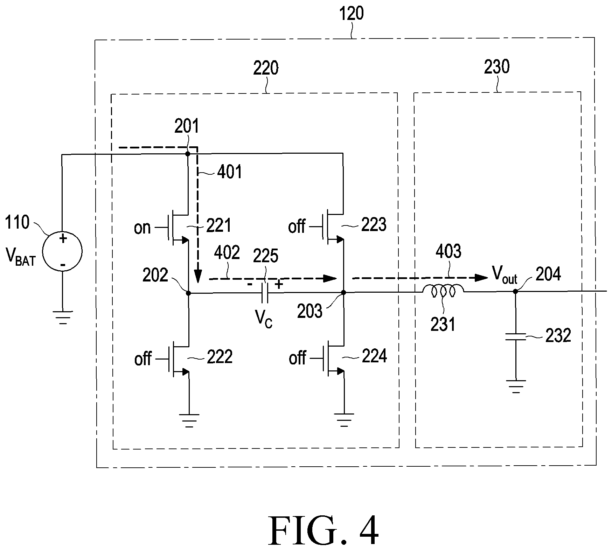

FIG. 4 is a diagram illustrating an operation of a power input circuit and an electronic device according to an embodiment.

A second mode may be described with reference to FIG. 4. The "second mode" may be a mode in which switching power having a voltage with a magnitude substantially two times of that of the voltage of the input power input to the charge pump 220 is output to the input node 203 of the LC filter 230. The charge pump 220 may output, based on the second mode and to the input node 203 of the LC filter 230, switching power having a voltage with a magnitude substantially two times of that of the voltage of the input power input to the charge pump 220. The second mode may be a combination of the first switch 221 being turned on, the second switch 222 being turned off, the third switch 223 being turned off, and the fourth switch 224 being turned off. The processor 140 may control the charge pump 220 so that the charge pump 220 operates in the second mode. The processor 140 may control the charge pump 220 in the second mode to output, via the charge pump 220, switching power having a voltage with a magnitude substantially two times of that of input power. The processor 140 may control the first switch 221 to be turned on, the second switch 222 to be turned off, the third switch 223 to be turned off, and the fourth switch 224 to be turned off, so as to allow the charge pump 220 to operate in the second mode. Referring to FIG. 4, in the second mode, the input power provided from the power source 110 may be transferred to the first node 202 of the first capacitor 225 through a first path 401 including the first switch 221. In the second mode, switching power having a voltage with a magnitude substantially two times of that of the voltage of the input power provided from the power source 110 may be provided to the input node 203 of the LC filter 230, based on a second path 402 including the first capacitor 225. In the second mode, the LC filter 230 may receive, through a third path 403, switching power having a voltage with a magnitude substantially two times of that of the voltage (e.g., input voltage) of the input power provided from the power source 110.

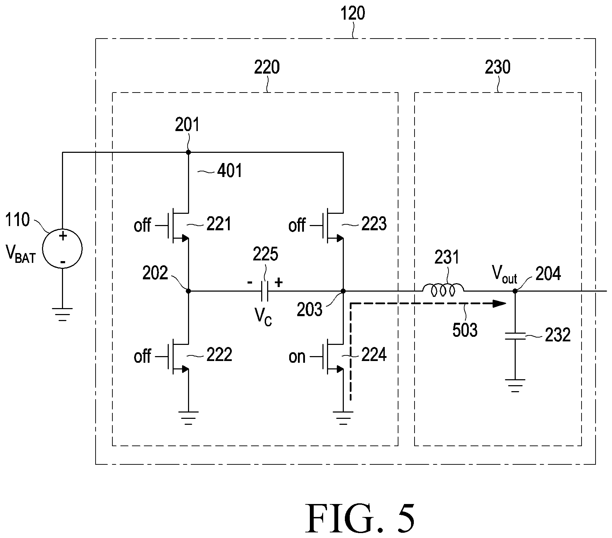

FIG. 5 is a diagram illustrating an operation of a power input circuit and an electronic device according to an embodiment.

A third mode may be described with reference to FIG. 5. The "third mode" may be a mode in which the charge pump 220 does not output switching power to the input node 203 of the LC filter 230. The charge pump 220 may not output switching power, based on the third mode. The third mode may be a combination of the first switch 221 being turned off, the second switch 222 being turned off, the third switch 223 being turned off, and the fourth switch 224 being turned on. The processor 140 may control the charge pump 220 so that the charge pump 220 operates in the third mode. The processor 140 may control the charge pump 220 in the third mode in order not to output switching power via the charge pump 220. The processor 140 may control the first switch 221 to be turned off, the second switch 222 to be turned off, the third switch 223 to be turned off, and the fourth switch 224 to be turned on, so as to allow the charge pump 220 to operate in the third mode. In the third mode, the LC filter 230 may not be provided with switching power. The LC filter 230 not being provided with switching power may be also expressed as, with reference to FIG. 5, the LC filter 230 being connected to the ground through a third path 503.

Referring to FIG. 3, FIG. 4, and FIG. 5, the charge pump 220 may switch among the first mode, the second mode, and/or the third mode, thereby outputting switching power to the LC filter 230 through the input node 203 of the LC filter 230. The processor 140 may control the charge pump 220 (e.g., the switches 221, 222, 223, and 224 included in the charge pump 220) to enable the charge pump 220 to switch among the first mode, the second mode, and/or the third mode, so as to output switching power to the LC filter 230 through the input node 203 of the LC filter 230.

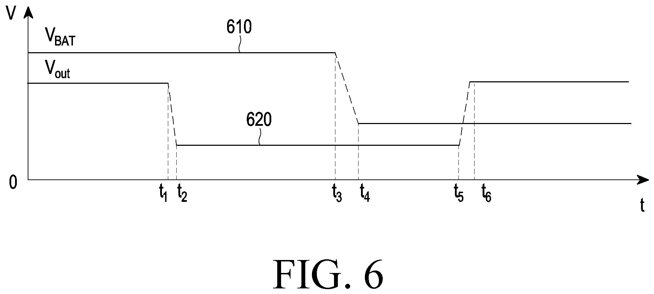

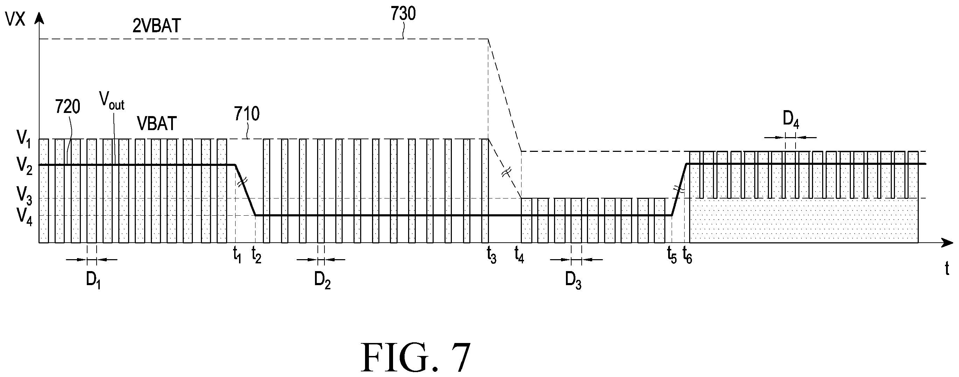

FIG. 6 is a diagram illustrating an operation of a power input circuit and an electronic device according to an embodiment. FIG. 7 is a diagram illustrating an operation of a power input circuit and an electronic device according to an embodiment.

Referring to FIG. 6 and FIG. 7, control of a duty cycle of the switches 221, 222, 223, and 224 included in the charge pump 220 may be understood.

FIG. 6 is a graph showing, over time, an input voltage 610 (e.g., V_{BAT}) of the input power provided from the power source 110 and an output voltage 620 (e.g., Vₒᵤₜ) of the output power output from an output node of the power input circuit 120. The output voltage 620 may be a necessary voltage at the output node 204 of the LC filter 230. The "necessary voltage" may be a voltage having a magnitude required for an operation of a load (e.g., the load 130 of FIG. 1). The processor 140 may identify a necessary voltage (e.g., a necessary voltage of output power) at the output node 204 of the LC filter 230. The processor 140 may control the charge pump 220, based on a necessary voltage (e.g., a necessary voltage of output power) at the output node 204 of the LC filter 230. The processor 140 may control duty cycle of the first switch 221, the second switch 222, the third switch 223, and/or the fourth switch 224, based on a necessary voltage (e.g., a necessary voltage of output power) at the output node 204 of the LC filter 230. For example, in a case where a voltage of 4 V is required for an operation of a load (e.g., the load 130 of FIG. 1), a necessary voltage at the output node may be 4 V, and the processor 140 may control the charge pump 220 (e.g., the switches 221, 222, 223, and 224 of the charge pump 220) so that the voltage of 4V is output through the output node 204 of the LC filter 230 via the power input circuit 120. Referring to FIG. 6, a constant magnitude of necessary voltage is required up to t₁. The magnitude of the necessary voltage after t₂ is smaller than that before t₁. A constant magnitude of input voltage has been input up to t₃, and the magnitude of the input voltage is smaller after t₄. The magnitude of the necessary voltage after t₆ is larger than that before t₅, and exceeds the magnitude of the input voltage after t₆. In the state of FIG. 6, in order to provide output power having an output voltage corresponding to a necessary voltage, a method of controlling the charge pump 220 by the processor 140 will be described with reference to FIG. 7.

A case where an input voltage (e.g., V_{BAT}) is greater than a necessary voltage (e.g., Vₒᵤₜ) and a case where an input voltage (e.g., V_{BAT}) is smaller than a necessary voltage (e.g., Vₒᵤₜ) are described.

In FIG. 7, reference numeral 710 indicates the magnitude of an input voltage. Reference numeral 720 indicates the magnitude of an output voltage (necessary voltage). Reference numeral 730 indicates a magnitude which is two times of the magnitude of the input voltage. In FIG. 7, a bar graph shows the voltage of switching power. For example, in FIG. 7, it may be noted that until t₁, the voltage of the switching power input to the input node 203 of the LC filter 230 switches between the input voltage (e.g., V_{BAT}= V₁) and a ground voltage (e.g., 0 V). For example, in FIG. 7, it may be noted that after t₆, the voltage of the switching power input to the input node 203 of the LC filter 230 switches between the input voltage (e.g., V_{BAT}= V₃) and a voltage with a magnitude two times of that of the input voltage (e.g., V_{BAT}= V₃).

Referring to FIG. 7, the input voltage up to t₅ may be greater than the necessary voltage. The input voltage (e.g., V_{BAT}) maintains V₁ until t₃, decreases to V₃ at t₄, and may maintain V₃ until t₅. The necessary voltage (e.g., Vₒᵤₜ) maintains V₂ until t₁, decreases to V₄ at t₂, and may maintain V₄ until t₅. In this case, an operation of the charge pump 220 may be as follows.

For example, until t₁, the processor 140 may control the charge pump 220 such that the charge pump 220 switches between a first mode (e.g., the first mode of FIG. 3) and a third mode (e.g., the third mode of FIG. 5). According to the charge pump 220 switching between the first mode (e.g., the first mode of FIG. 3) and the third mode (e.g., the third mode of FIG. 5), the output voltage of the output power output through the output node 204 of the LC filter 230 may be determined within a range equal to or smaller than the input voltage of the input power provided from the power source 110. The processor 140 may control, until t₁, the first switch 221 to be turned off, and switch the second switch 222, the third switch 223, and the fourth switch 224 to be turned on/off. The processor 140 may control the duty cycle of the second switch 222, the third switch 223, and the fourth switch 224 until t₁, to control the charge pump 220 such that the charge pump 220 switches between the first mode (e.g., the first mode of FIG. 3) and the third mode (e.g., the third mode of FIG. 5), so that the output voltage (e.g., Vₒᵤₜ) of the output power output through the output node 204 of the LC filter 230 is included in a range equal to or smaller than the input voltage (e.g., V_{BAT}) of the input power provided from the power source 110.

For example, from t₂ to t₃, the processor 140 may control the charge pump 220 such that the charge pump 220 switches between the first mode (e.g., the first mode of FIG. 3) and the third mode (e.g., the third mode of FIG. 5). The processor 140 may control, from t₂ to t₃, the first switch 221 to be turned off, and switch the second switch 222, the third switch 223, and the fourth switch 224 to be turned on/off. The processor 140 may control the duty cycle of the second switch 222, the third switch 223, and the fourth switch 224 from t₂ to t₃, to control the charge pump 220 such that the charge pump 220 switches between the first mode (e.g., the first mode of FIG. 3) and the third mode (e.g., the third mode of FIG. 5), so that the output voltage (e.g., Vₒᵤₜ) of the output power output through the output node 204 of the LC filter 230 is included in a range equal to or smaller than the input voltage (e.g., V_{BAT}) of the input power provided from the power source 110. For example, based on the necessary voltage being smaller than the existing output voltage while the input voltage is constant, the processor 140 may adjust a duty cycle for maintaining the first mode to be shortened. For example, in FIG. 7, the processor 140 may adjust a second duty cycle (e.g., D₂) for maintaining the first mode from t₂ to t₃, to be shorter than a first duty cycle (e.g., D₁) for maintaining the first mode until t₁, based on the output voltage (e.g., V₂) until t₁ being lower than the necessary voltage (e.g., V₄) from t₂ to t₃. Unlike FIG. 7, based on the necessary voltage being greater than the existing output voltage while the input voltage is constant, the processor 140 may adjust a duty cycle for maintaining the first mode to be extended. For example, when the necessary voltage until t₁ is V₂ and the necessary voltage from t₂ to t₃ is greater than V₂, the processor 140 may control the charge pump 220 so that the second duty cycle for maintaining the first mode from t₂ to t₃ is shorter than the first duty cycle for maintaining the first mode until t₁.

For example, from t₄ to t₅, the processor 140 may control the charge pump 220 such that the charge pump 220 switches between the first mode (e.g., the first mode of FIG. 3) and the third mode (e.g., the third mode of FIG. 5). The processor 140 may control, from t₄ to t₅, the first switch 221 to be turned off, and switch the second switch 222, the third switch 223, and the fourth switch 224 to be turned on/off. The processor 140 may control the duty cycle of the second switch 222, the third switch 223, and the fourth switch 224 from t₄ to t₅, to control the charge pump 220 such that the charge pump 220 switches between the first mode (e.g., the first mode of FIG. 3) and the third mode (e.g., the third mode of FIG. 5), so that the output voltage (e.g., Vₒᵤₜ) of the output power output through the output node 204 of the LC filter 230 is included in a range equal to or smaller than the input voltage (e.g., V_{BAT}) of the input power provided from the power source 110. For example, based on the input voltage decreasing compared to the existing input voltage while the necessary voltage is constant, the processor 140 may adjust a duty cycle for maintaining the first mode to be extended. For example, while the necessary voltage remains constant from t₂ to t₅, according to the decrease of the input voltage after t₄ compared to the input voltage before t₃, the processor 140 may control the charge pump 220 so that a third duty cycle (e.g., D₃) for maintaining the first mode from t₄ to t₅ becomes longer than the second duty cycle (e.g., D₂) for maintaining the first mode from t₂ to t₃. Unlike FIG. 7, based on the input voltage increasing compared to the existing input voltage while the necessary voltage is constant, the processor 140 may adjust a duty cycle for maintaining the first mode to be shortened. For example, while the necessary voltage remains constant from t₂ to t₅, according to the increase of the input voltage after t₄ compared to the input voltage before t₃, the processor 140 may control the charge pump 220 so that the third duty cycle for maintaining the first mode from t₄ to t₅ becomes shorter than the second duty cycle for maintaining the first mode from t₂ to t₃.

Referring to FIG. 7, the input voltage after t₆ may be smaller than the necessary voltage. The input voltage (e.g., V_{BAT}) may maintain V₃ after t₄. The necessary voltage (e.g., Vₒᵤₜ) maintains V₄ until t₅, increases to V₂ at t₆, and may maintain V₂ thereafter. V₃ may be smaller than V₂. In this case, an operation of the charge pump 220 may be as follows.

For example, after t₆, the processor 140 may control the charge pump 220 such that the charge pump 220 switches between a first mode (e.g., the first mode of FIG. 3) and a second mode (e.g., the second mode of FIG. 4). According to the charge pump 220 switching between the first mode (e.g., the first mode of FIG. 3) and the second mode (e.g., the second mode of FIG. 4), the output voltage of the output power output through the output node 204 of the LC filter 230 may be determined within a range equal to or smaller than the input voltage of the input power provided from the power source 110. The processor 140 may control, after t₆, the fourth switch 224 to be turned off, and switch the first switch 221, the second switch 222, and the third switch 223 to be turned on/off. The processor 140 may control the duty cycle of the first switch 221, the second switch 222, and the third switch 223 after t₆, to control the charge pump 220 such that the charge pump 220 switches between the first mode (e.g., the first mode of FIG. 2) and the second mode (e.g., the second mode of FIG. 4), so that the output voltage (e.g., Vₒᵤₜ) of the output power output through the output node 204 of the LC filter 230 is included in a range equal to or smaller than a voltage with a magnitude substantially two times of that of the input voltage (e.g., V_{BAT}) of the input power provided from the power source 110 and equal to or greater than the input voltage (e.g., V_{BAT}). According to the magnitude of the necessary voltage after t₆, the processor 140 may control a duty cycle (e.g., D₄) of the first switch 221, the second switch 222, and the third switch 223.

A person skilled in the art may understand that embodiments disclosed in this specification may be applied cooperatively with each other in an applicable range. For example, a person skilled in the art may understand that at least some operations of an embodiment described in this specification may be omitted and that at least some operations of an embodiment may be integrally connected with at least some operations of another embodiment.

According to an embodiment, a power input circuit 120 may include a charge pump 220 and an LC filter 230. The charge pump 220 may include a first switch 221 configured to receive input power from a power source 110, the input power being input through a first end of the first switch 221. The charge pump 220 may include a second switch 222 electrically connected to the first switch 221, a second end of the first switch 221 being electrically connected to a first end of the second switch 222, and a second end of the second switch 222 being electrically connected to the ground. The charge pump 220 may include a third switch 223 configured to receive the input power from the power source 110, the input power being input through a first end of the third switch 223. The charge pump 220 may include a fourth switch 224 electrically connected to the third switch 223, a second end of the third switch 223 being electrically connected to a first end of the fourth switch 224, and a second end of the fourth switch 224 being electrically connected to the ground. The charge pump 220 may include a first capacitor 225, a first end of the first capacitor (225) being electrically connected to the second end of the first switch 221, and a second end of the first capacitor (225) being electrically connected to the second end of the third switch 223. The LC filter 230 may include a first inductor 231 and a second capacitor 232. The first inductor 231 of the LC filter 230 may be electrically connected to the second end of the first capacitor 225.

According to an embodiment, every element of the power input circuit 120 electrically connected to another element may be directly electrically connected.

According to an embodiment, the second end of the first capacitor 225 may be connected to an input node 203 of the LC filter 230. The charge pump 220 may be configured to output switching power to the input node 203 of the LC filter 230, based on the input power. The LC filter 230 may be configured to receive the switching power via the first inductor 231, and output an output power through an output node 204 of the LC filter 230 between the first inductor 231 and the second capacitor 232, based on the switching power.

According to an embodiment, the charge pump 220 may be configured to, based on a first mode, output the switching power having a voltage with a magnitude substantially identical to an input voltage of the input power. The first mode may be a combination of the first switch 221 being turned off, the second switch 222 being turned on, the third switch 223 being turned on, and the fourth switch 224 being turned off.

According to an embodiment, the first capacitor 225 may be configured to be charged, based on the first mode, to have a voltage with a magnitude substantially identical to the input voltage of the input power.

According to an embodiment, the charge pump 220 may be configured to, based on a second mode, output the switching power having a voltage with a magnitude substantially two times of an input voltage of the input power. The second mode may be a combination of the first switch 221 being turned on, the second switch 222 being turned off, the third switch 223 being turned off, and the fourth switch 224 being turned off.

According to an embodiment, the charge pump 220 may be configured not to output the switching power, based on a third mode. The third mode may be a combination of the first switch 221 being turned off, the second switch 222 being turned off, the third switch 223 being turned off, and the fourth switch 224 being turned on.

According to an embodiment, an output voltage of the output power may be determined based on a duty cycle of the first switch 221, the second switch 222, the third switch 223, and/or the fourth switch 224.

According to an embodiment, in order to decrease the output voltage of the output power, the duty cycle may be adjusted to be shortened. In order to increase the output voltage of the output power, the duty cycle may be adjusted to be extended.

According to an embodiment, an output voltage of the output power may be determined within a range equal to or smaller than a voltage with a magnitude substantially two times of that of an input voltage of the input power and equal to or greater than the input voltage, as the charge pump 220 switches between the first mode and the second mode.

According to an embodiment, an output voltage of the output power may be determined within a range equal to or smaller than an input voltage of the input power, as the charge pump 220 switches between the first mode and the third mode.

The power input circuit 120 according to the disclosure has the advantage of reducing the chip size because it can be constructed using reduced number of switches compared to the prior art. Additionally, the power input circuit 120 according to the invention has improved efficiency. According to an embodiment, the number of switches included in the power input circuit 120 is limited to four. According to an embodiment, the switches are metal-oxide-semiconductor field-effect transistors (MOSFET).

According to an embodiment, an electronic device may include a charge pump 220, an LC filter 230, and a processor 140. The charge pump 220 may include a first switch 221 configured to receive input power from a power source 110, the input power being input through a first end of the first switch 221. The charge pump 220 may include a second switch 222 electrically connected to the first switch 221, a second end of the first switch 221 being electrically connected to a first end of the second switch 222, and a second end of the second switch 222 being electrically connected to the ground. The charge pump 220 may include a third switch 223 configured to receive the input power from the power source 110, the input power being input through a first end of the third switch 223. The charge pump 220 may include a fourth switch 224 electrically connected to the third switch 223, a second end of the third switch 223 being electrically connected to a first end of the fourth switch 224, and a second end of the fourth switch 224 being electrically connected to the ground. The charge pump 220 may include a first capacitor 225, a first end of the first capacitor (225) being electrically connected to the second end of the first switch 221, and a second end of the first capacitor (225) being electrically connected to the second end of the third switch 223. The LC filter 230 may include a first inductor 231 and a second capacitor 232. The first inductor 231 of the LC filter 230 may be electrically connected to the second end of the first capacitor 225.

According to an embodiment, the second end of the first capacitor 225 may be connected to an input node 203 of the LC filter 230. The charge pump 220 may be configured to output switching power to the input node 203 of the LC filter 230, based on the input power. The LC filter 230 may be configured to receive the switching power via the first inductor 231, and output an output power through an output node 204 of the LC filter 230 between the first inductor 231 and the second capacitor 232, based on the switching power.

According to an embodiment, the processor 140 may be configured to control the charge pump 220 in a first mode to output, via the charge pump 220, the switching power having a voltage with a magnitude substantially identical to that of an input voltage of the input power. The first mode may be a combination of the first switch 221 being turned off, the second switch 222 being turned on, the third switch 223 being turned on, and the fourth switch 224 being turned off.

According to an embodiment, the first capacitor 225 may be configured to, based on the first mode, be charged to have a voltage with a magnitude substantially identical to the input voltage of the input power.

According to an embodiment, the processor 140 may be configured to control the charge pump 220 in a second mode to output, via the charge pump 220, the switching power having a voltage with a magnitude substantially two times of an input voltage of the input power. The second mode may be a combination of the first switch 221 being turned on, the second switch 222 being turned off, the third switch 223 being turned off, and the fourth switch 224 being turned off.

According to an embodiment, the processor 140 may be configured to control the charge pump 220 in a third mode in order not to output the switching power via the charge pump 220. The third mode may be a combination of the first switch 221 being turned off, the second switch 222 being turned off, the third switch 223 being turned off, and the fourth switch 224 being turned on.

According to an embodiment, the processor 140 may be configured to control the charge pump 220 in the first mode, the second mode and/or the third mode.

According to an embodiment, the processor 140 may identify a necessary voltage of the output power. The processor 140 may be configured to control a duty cycle of the first switch 221, the second switch 222, the third switch 223, and/or the fourth switch 224, based on the necessary voltage.

According to an embodiment, the processor 140 may be configured to adjust the duty cycle to be shortened, based on the necessary voltage of the output power being smaller than an existing output voltage of the output power. The processor 140 may be configured to adjust the duty cycle to be extended, based on the necessary voltage of the output power being greater than an existing output voltage of the output power.

According to an embodiment, the processor 140 may be configured to control the charge pump 220 to switch between the first mode and the second mode such that an output voltage of the output power is included in a range equal to or smaller than a voltage with a magnitude substantially two times of an input voltage of the input power and equal to or greater than the input voltage.

According to an embodiment, the processor 140 may be configured to control the charge pump 220 to switch between the first mode and the third mode such that an output voltage of the output power is included in a range equal to or smaller than an input voltage of the input power.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., a program) including one or more instructions that are stored in a storage medium (e.g., an internal memory or external memory) that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A power input circuit (120) comprising:
a charge pump (220); and
an LC filter (230),
wherein the charge pump (220) comprises:
a first switch (221) configured to receive input power from a power source (110), the input power being input through a first end of the first switch (221);
a second switch (222) electrically connected to the first switch (221), a second end of the first switch (221) being electrically connected to a first end of the second switch (222), and a second end of the second switch (222) being electrically connected to the ground;
a third switch (223) configured to receive the input power from the power source (110), the input power being input through a first end of the third switch (223);
a fourth switch (224) electrically connected to the third switch (223), a second end of the third switch (223) being electrically connected to a first end of the fourth switch (224), and a second end of the fourth switch (224) being electrically connected to the ground; and
a first capacitor (225), a first end of the first capacitor (225) being electrically connected to the second end of the first switch (221), and a second end of the first capacitor (225) being electrically connected to the second end of the third switch (223),
wherein the LC filter (230) comprises a first inductor (231) and a second capacitor (232), and
wherein the first inductor (231) of the LC filter (230) is electrically connected to the second end of the first capacitor (225).

2. The power input circuit (120) of claim 1, wherein the second end of the first capacitor (225) is electrically connected to an input node (203) of the LC filter (230),
wherein the charge pump (220) is configured to output switching power to the input node (203) of the LC filter (230), based on the input power, and
wherein the LC filter (230) is configured to receive the switching power via the first inductor (231), and output an output power through an output node (204) of the LC filter (230) between the first inductor (231) and the second capacitor (232), based on the switching power.

3. The power input circuit (120) of claim 1 or 2, wherein the charge pump (220) is configured to, based on a first mode, output the switching power having a voltage with a magnitude substantially identical to an input voltage of the input power, and
wherein the first mode is a combination of the first switch (221) being turned off, the second switch (222) being turned on, the third switch (223) being turned on, and the fourth switch (224) being turned off.

4. The power input circuit (120) of claim 3, wherein the first capacitor (225) is configured to be charged, based on the first mode, to have a voltage with a magnitude substantially identical to the input voltage of the input power.

5. The power input circuit (120) of one of claims 1 to 4, wherein the charge pump (220) is configured to, based on a second mode, output the switching power having a voltage with a magnitude substantially two times of an input voltage of the input power, and
wherein the second mode is a combination of the first switch (221) being turned on, the second switch (222) being turned off, the third switch (223) being turned off, and the fourth switch (224) being turned off.

6. The power input circuit (120) of one of claims 1 to 5, wherein the charge pump (220) is configured not to output the switching power, based on a third mode, and
wherein the third mode is a combination of the first switch (221) being turned off, the second switch (222) being turned off, the third switch (223) being turned off, and the fourth switch (224) being turned on.

7. The power input circuit (120) of one of claims 1 to 6, wherein an output voltage (620) of the output power is determined based on a duty cycle of the first switch (221), the second switch (222), the third switch (223), and/or the fourth switch (224).

8. The power input circuit (120) of claim 7, wherein, in order to decrease the output voltage (620) of the output power, the duty cycle is adjusted to be shortened, and
wherein, in order to increase the output voltage (620) of the output power, the duty cycle is adjusted to be extended.

9. The power input circuit (120) of one of claims 1 to 6, wherein an output voltage (620) of the output power is determined within a range equal to or smaller than a voltage with a magnitude substantially two times of an input voltage of the input power and equal to or greater than the input voltage, as the charge pump (220) switches between the first mode and the second mode; and/or
wherein the output voltage (620) of the output power is determined within a range equal to or smaller than an input voltage of the input power, as the charge pump (220) switches between the first mode and the third mode.

10. An electronic device comprising:
a power input circuit (120) of any one of the preceding claims;
a power source (110); and
a processor (140).

11. The electronic device of claim 10, wherein the processor (140) is configured to control the charge pump (220) in a first mode, a second mode and/or a third mode.

12. The electronic device of one of claims 10 and 11, wherein the processor (140) is configured to:
identify a necessary voltage of the output power; and
control a duty cycle of the first switch (221), the second switch (222), the third switch (223), and/or the fourth switch (224), based on the necessary voltage.

13. The electronic device of claim 12, wherein the processor (140) is configured to:
adjust the duty cycle to be shortened, based on the necessary voltage of the output power being smaller than an existing output voltage of the output power; and
adjust the duty cycle to be extended, based on the necessary voltage of the output power being greater than the existing output voltage of the output power.

14. The electronic device of one of claims 11 to 13, wherein the processor (140) is configured to control the charge pump (220) to switch between the first mode and the second mode such that an output voltage of the output power is included in a range equal to or smaller than a voltage with a magnitude substantially two times of an input voltage of the input power and equal to or greater than the input voltage.

15. The electronic device of one of claims 11 to 14, wherein the processor (140) is configured to control the charge pump (220) to switch between the first mode and the third mode such that an output voltage of the output power is included in a range equal to or smaller than an input voltage of the input power.
